(19) Europäisches Patentamt
European Patent Office
Office européen des brevets

(11) Numéro de publication : **0 522 979 A1**

(12) **DEMANDE DE BREVET EUROPEEN**

(21) Numéro de dépôt : **92402029.0**

(22) Date de dépôt : **13.07.92**

(51) Int. Cl.$^5$ : **C23C 16/26,** C23C 16/30

(30) Priorité : **12.07.91 FR 9108811**

(43) Date de publication de la demande : **13.01.93 Bulletin 93/02**

(84) Etats contractants désignés : **BE DE ES FR GB**

(71) Demandeur : **APPLICATIONS COUCHES MINCES ACM**
**9 Rue de la Gare**
**F-78640 Villiers Saint Frederic (FR)**

(72) Inventeur : **Durand, Anne-Marie**
**9, rue des Coquelicots**
**F-28410 Boutigny Sur Opton (FR)**
Inventeur : **Enke, Knut**
**Am Wingert 19**
**W-8752 Johannesberg (DE)**

(74) Mandataire : **Tonnellier, Jean-Claude et al**
**Cabinet Nony & Cie. 29, rue Cambacérès**
**F-75008 Paris (FR)**

(54) **Substrat revêtu d'une couche mince à base de carbone dur amorphe additionné de silicium, sa préparation et son utilisation.**

(57) Substrat solide revêtu sur au moins une partie de sa surface, d'une couche mince constituée essentiellement de carbone dur amorphe additionné de silicium ; sa préparation par la méthode de dépôt chimique assisté par plasma ; et son utilisation notamment comme revêtement protecteur contre les agents chimiques, comme revêtement anti-usure, comme revêtement isolant électrique, comme revêtement décoratif ou comme revêtement conducteur de la chaleur.

EP 0 522 979 A1

La présente invention a pour objet un substrat solide dont au moins une partie de la surface est revêtue d'une couche mince à base de carbone et de silicium.

On sait que le dépôt chimique en phase gazeuse, ou CVD (Chemical Vapor Deposition) constitue une méthode intéressante pour le dépôt de couches minces sur des substrats.

Toutefois, le procédé CVD nécessite le chauffage du substrat à des températures élevées, ce qui limite l'application de ce procédé à des substrats et des matériaux capables de résister à ces températures.

On connaît par ailleurs l'intérêt du dépôt de couches minces de carbone dur amorphe comme couches protectrices ayant notamment un faible coefficient de friction et une dureté élevée.

On a décrit récemment un procédé de dépôt de couche mince de carbone dur amorphe par la méthode de dépôt chimique en phase gazeuse assisté par plasma (désignée par le sigle PCVD ou encore par CVD-plasma) ; voir notamment BONETTI et al., SURFACE n° 220, mars 1991.

Le dépôt de couches minces par PCVD permet de limiter, lors du traitement, la température des pièces, et aussi de minimiser les rejets polluants.

Le principe du procédé PCVD est rappelé ci-après. On opère dans une enceinte associée à un groupe de pompage permettant d'établir un vide inférieur à $10^{-3}$ Pa. Les objets à traiter sont déposés sur une électrode reliée à un générateur haute fréquence. Une seconde électrode (en pratique la paroi de l'enceinte) est reliée à la terre. L'enceinte est également munie de moyens permettant l'introduction sous faible pression des réactifs gazeux. Le champ électrique créé dans l'enceinte provoque l'ionisation du gaz résiduel en électrons et ions positifs, avec formation d'un plasma conducteur. Grâce à l'utilisation du courant haute fréquence, l'oscillation des électrons du plasma permet d'entretenir l'ionisation. En raison de la mobilité élevée des électrons par rapport aux ions positifs du plasma, l'électrode et les pièces à traiter deviennent chargées négativement. Il en résulte que les ions positifs sont accélérés vers les pièces déposées sur l'électrode, et un dépôt solide se forme alors sur lesdites pièces. Ce dépôt est soumis durant sa constitution à un bombardement d'ions qui donne naissance à une structure amorphe dense et très dure, car les atomes les plus faiblement liés en surface sont expulsés.

Dans le cas où le réactif gazeux est un hydrocarbure, on obtient un dépôt très dur amorphe se composant d'un réseau de liaisons carbone-carbone à disposition irrégulière contenant à la fois des liaisons sp3 (comme dans le diamant) et sp2 (comme dans le graphite), avec une certaine proportion de liaisons C-H qui stabilisent les valences libres. Pour ces raisons, un tel carbone amorphe hydrogéné est parfois désigné par l'abréviation a-C:H ("a" pour : amorphe), ou encore DLC (Diamond-Like Carbon). Ce carbone amorphe hydrogéné est souvent appelé "carbone dur" ou "carbone dur amorphe".

Il est possible d'améliorer les propriétés des couches minces de carbone dur amorphe par addition de silicium. Par rapport au DLC, les couches minces dopées au silicium présentent notamment les avantages suivants :

- meilleure adhérence des couches,
- meilleure tenue en température,
- meilleure élasticité intrinsèque.

L'avantage résultant de la meilleure tenue en température et de la meilleure adhérence est évident. L'élasticité intrinsèque des couches permet notamment d'améliorer la résistance à l'usure par abrasion et à l'usure par fatigue des matériaux, dans les cas de pièces soumises à des frottements et/ou à des contraintes mécaniques.

Lorsqu'on veut obtenir un revêtement de carbone amorphe très dur, l'avantage d'une couche intermédiaire contenant du silicium est d'éviter que le revêtement très dur constituant la couche la plus superficielle ne soit cassant.

On a maintenant découvert qu'en préparant un revêtement (couche mince) de carbone dur amorphe selon la méthode PCVD en présence d'argon, il est possible d'obtenir un revêtement d'une dureté très élevée, qu'il n'est pas possible d'atteindre avec les méthodes connues. En outre, lorsque l'argon est présent dès le début de l'opération de PCVD, il favorise l'adhérence de la couche de carbone-silicium déposée. Les revêtements ainsi obtenus, soumis à un bombardement d'ions argon pendant au moins une partie du procédé de formation du revêtement, sont facilement caractérisables car ils contiennent de l'argon, détectable par exemple en analyse aux rayons X.

La présente invention a donc pour objet un substrat solide revêtu, sur au moins une partie de sa surface, d'une couche mince de carbone dur amorphe, caractérisé par le fait que ledit carbone dur amorphe est additionné de silicium et contient de l'argon.

La proportion atomique d'argon dans la couche mince est généralement comprise entre 0,1 et 10 % et en particulier entre 1 et 5 %.

La teneur en silicium de la couche mince peut être sensiblenent uniforme sur toute son épaisseur, ou bien peut décroître depuis les couches profondes vers les couches superficielles, et même devenir nulle dans les couches les plus superficielles. Dans les couches minces de l'invention, la proportion atomique

$$Si/(Si + C)$$

peut varier par exemple de 5 à 50 %, et en particulier de 10 à 40 %.

De même, la teneur en argon du revêtement peut varier, en fonction du procédé utilisé pour sa préparation, selon que l'argon n'est employé que pendant une partie, ou pendant la totalité, de l'étape de dépôt

de la couche mince.

La couche mince obtenue selon l'invention peut contenir en outre des agents dopants, par exemple au moins un agent dopant choisi notamment parmi le bore, le phosphore, l'azote, le fluor.

La teneur totale en agents dopants est le plus souvent inférieure à 10 % (proportion atomique par rapport à l'ensemble des constituants de la couche mince), et est généralement inférieure à la teneur en silicium.

L'invention a également pour objet un procédé de préparation d'un substrat revêtu d'une couche mince telle que définie ci-dessus. Ce procédé, mis en oeuvre selon la méthode PCVD, est caractérisé par le fait que l'on utilise comme réactif gazeux au moins un gaz contenant du silicium, éventuellement en mélange avec un hydrocarbure gazeux si le gaz contenant du silicium ne contient pas de carbone, et par le fait que ledit réactif gazeux contient de l'argon pendant au moins une partie de la durée du procédé de dépôt de la couche mince.

D'une façon générale, la présence d'argon pendant la mise en oeuvre du procédé permet d'obtenir un bon accrochage, et donc une bonne adhérence, des couches déposées. Pour cette raison, l'argon est généralement présent dans le réactif gazeux pendant la plus grande partie (au moins 60 %) et de préférence pendant la totalité, du temps de mise en oeuvre du procédé de dépôt de la couche mince.

Comme gaz contenant du silicium, on utilise notamment des silanes de formule générale I

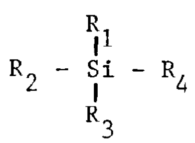

(I)

dans laquelle $R_1$, $R_2$, $R_3$, $R_4$ représentent indépendamment -H ou un groupement alkyle ayant de 1 à 3 atomes de carbone, étant entendu que l'un au moins des substituants $R_1$ - $R_4$ est différent de H.

On peut également utiliser $SiF_4$ (comme réactif gazeux contenant du silicium) en mélange avec un hydrocarbure ou avec un organosilane.

Il est évident que l'on pourra régler la teneur en silicium du dépôt par le choix du réactif gazeux, en fonction par exemple du rapport Si/(Si + C) du silane de départ. En outre, il est possible de faire varier la teneur en silicium en introduisant dans l'enceinte réactionnelle un mélange du réactif gazeux contenant du silicium (par exemple silane) et d'au moins un hydrocarbure gazeux. Un tel mélange peut être utilisé dès le début de la réaction, ou bien en cours de réaction de façon à obtenir un dépôt ayant des couches superficielles plus riches en carbone que les couches profondes. Il est également possible de faire varier les teneurs respectives de ces réactifs, en cours de réaction, pour obtenir des couches minces à teneurs décroissantes en silicium. Il est encore possible de terminer la réaction avec un hydrocarbure comme seul réactif gazeux, de façon à obtenir une couche mince dont les couches superficielles sont constituées uniquement de carbone dur amorphe. L'un des avantages d'une telle couche externe sans silicium est que sa biocompatibilité est établie. L'intérêt du silicium à l'interface substrat-couche mince est notamment, dans un tel cas, l'augmentation de l'adhérence de la couche déposée.

La proportion de l'argon, pendant le temps où il est présent dans le réactif gazeux, est généralement comprise entre 10 et 60 % en volume.

Pour introduire dans la couche mince les dopants tels que ceux mentionnés ci-dessus, on utilise un réactif gazeux de départ qui contient en outre au moins un agent dopant choisi parmi l'azote et/ou un précurseur gazeux d'un agent dopant choisi parmi le bore, le phosphore et le fluor. Parmi les précurseurs gazeux d'agent(s) dopant(s), on peut citer $N_2F_4$, $CF_2$, $SiF_4$, $PF_5$, $PH_3$ et $BF_3$.

Dans le procédé de l'invention, on met en oeuvre la méthode PCVD selon les techniques usuelles. Par exemple, après avoir fait le vide dans l'enceinte (jusqu'à une pression inférieure à $10^{-3}$ Pa) on introduit le réactif gazeux de départ à une pression relativement basse, pouvant aller par exemple de $1 \times 10^{-1}$ à $5 \times 10^{1}$ Pa. On applique ensuite une puissance haute fréquence (par exemple à 13,56 MHz) ou ultra-haute fréquence, qui est suffisante pour provoquer la formation d'un plasma, et qui fait apparaître une tension pouvant aller de 100 à 800 V.

Les couches minces de l'invention peuvent avoir par exemple une épaisseur allant de 0,1 à 20 µm, et en particulier de 1 à 5 µm.

Etant donné que le courant utilisé est un courant alternatif, le dépôt peut être effectué non seulement sur des substrats conducteurs de l'électricité, mais aussi sur des semi-conducteurs ou des isolants. Le substrat peut donc être quelconque. Toutefois certains métaux tels que le cuivre, le zinc et l'or ne permettent pas à obtenir des couches minces adhérentes, ce qui impose le dépôt d'une couche intermédiaire, par exemple d'aluminium. Il est évident que la détermination des matériaux convenant pour être utilisés comme substrats peut être effectuée par de simples expériences de routine. On utilisera de préférence des substrats capables de supporter une température au moins égale à 150°C.

Le substrat peut donc être notamment en un matériau comme un métal tel que le fer et les aciers divers, y compris l'acier inoxydable, l'aluminium, le nickel, le titane, le chrome, le cobalt, etc. ; des céramiques, par exemple d'alumine ; des semi-conducteurs, par exemple silicium ou germanium ; des verres ; des matériaux organiques, en particulier des matières plastiques telles que le polyéthylène, le

téflon (polytétrafluoroéthylène), le polyuréthane, etc...

Les couches minces obtenues selon l'invention présentent de nombreuses propriétés intéressantes : dureté, élasticité, transparence dans l'infra-rouge lointain, forte résistivité électrique, bonne conduction de la chaleur, résistance aux solvants du graphite et aux polymères hydrocarbonés. La réunion de ces propriétés font de ces couches minces un revêtement utilisable dans de nombreux domaines.

Les couches minces de l'invention peuvent servir notamment de revêtement protecteur contre les agents chimiques, de revêtements anti-usure, de revêtements isolants électriques, de revêtements conducteurs de la chaleur, etc.. Leur éclat métallique noir intense permet également de les utiliser dans un but décoratif, par exemple sur des pièces massives en matière plastique ou sur des métaux. Les pièces revêtues des couches minces selon l'invention peuvent être utilisées par exemple dans l'industrie mécanique, sous la forme d'outils de coupe, d'outils de formage, de roulements à billes ou à rouleaux, d'engrenages ; dans l'industrie des matières plastiques, par exemple pour le durcissement des moules ou leur protection contre les solvants ; dans l'industrie de l'optique, en particulier pour la protection des pièces d'optique infra-rouge ; dans l'industrie des prothèses médicales (la couche mince obtenue constitue un revêtement bio-compatible) ; etc.

Les exemples suivants illustrent l'invention.

<u>EXEMPLE I : Revêtement d'un substrat de silicium</u>

On opère à l'aide d'un appareil de PCVD muni d'un groupe de pompage permettant d'obtenir dans l'enceinte des pression inférieures à $10^{-3}$ Pa. L'enceinte est munie d'une vanne pour l'entrée du gaz ou du mélange gazeux.

On établit dans l'enceinte un vide de $10^{-4}$ Pa puis on introduit un mélange de réactifs gazeux à une pression de 0,1 Pa. On applique ensuite une tension de 600 V (fréquence : 13,56 MHz).

La pièce à revêtir, déposée sur l'électrode, est un substrat de silicium en forme de disque.

Le gaz réactionnel utilisé au début de l'opération est le tétraméthyl silane en mélange avec de l'argon (30 % en volume) qui permet de réaliser une couche d'accrochage, riche en silicium, particulièrement adhérente.

Au bout d'un temps de 40 min (correspondant à un dépôt d'une épaisseur de 1 μm environ), le réactif gazeux est mélangé à de l'hexane, à raison de 60 % d'hexane (en volume). Le réactif comprend alors 30 % d'argon et 10 % de tétraméthyl silane.

Au bout d'un temps de 90 min (correspondant à un dépôt d'une épaisseur de 2 μm environ), on arrête complètement l'introduction du tétraméthyl silane et on poursuit le dépôt avec un mélange d'hexane et d'argon (30 % en volume) comme réactif gazeux.

On arrête l'opération lorsque la couche mince déposée a une épaisseur totale de 3,5 μm.

<u>Etude des propriétés de la couche mince obtenue</u> :

a) <u>Mesure de l'élasticité</u> :

A l'aide de l'équipement microduromètre indenteur FISHER (Suisse) on mesure l'élasticité des couches en appliquant une déformation à l'aide d'un poinçon de diamant et en mesurant ensuite la déformation résiduelle, selon la méthode préconisée par le fabricant.

<u>Résultat</u> : 78 % (déformation résiduelle de 22 %).

b) <u>Mesure de la dureté</u> :

Avec le même équipement FISHER on mesure la dureté (déformation par rapport à la charge appliquée au poinçon) selon la méthode décrite par le fabricant.

<u>Résultat</u> : supérieure à 3000 kg/mm$^2$

c) <u>Mesure de l'adhérence</u> :

A l'aide d'un testeur d'adhérence par arrachage des couches (du type QUAD, commercialisé par INLAND) on mesure l'adhérence selon la méthode suivante : traction sur un plot collé avec une laque époxy à l'argent sur la surface de la couche.

<u>Résultat</u> : résistance à l'arrachage supérieure à 600 kg/cm$^2$.

d) <u>tenue en température</u> :

On met les échantillons dans une enceinte thermique à une température supérieure à 500°C pendant 2 heures, puis on effectue à nouveau les essais de mesure de l'élasticité, de la dureté et de l'adhérence.

<u>Résultat</u> : on n'observe pas de dégradation des propriétés.

e) <u>Analyse de la couche mince</u> :

Par spectroscopie infra-rouge, on note la présence de liaisons C-C (sp3), C-C (sp2), Si-C, Si-H et C-H.

En spectroscopie de masse, on trouve une teneur (% massique) en silicium de 30 % environ par rapport à la masse totale (Si + C).

Par analyse aux rayons X, on détecte la présence d'argon interstitiel.

<u>EXEMPLE 2 : Revêtement d'un substrat de verre</u>

L'enceinte utilisée est la même qu'à l'exemple 1.

On établit dans l'enceinte, un vide de $10^{-4}$ Pa puis on introduit un mélange de réactifs gazeux à une

pression de 0,1 Pa. On applique ensuite une tension de 800 V (fréquence : 13,56 MHz).

La pièce à revêtir, déposée sur l'électrode, est une plaque de verre.

Le gaz réactionnel utilisé au début de l'opération est le tétraméthyl silane, en mélange avec l'argon (50 % en volume).

On constate que de l'argon se dépose dans la couche mince, et que le bombardement de la couche avec les ions argon permet notamment d'éliminer une partie de l'hydrogène.

Au bout d'un temps de 30 min (correspondant à un dépôt d'une épaisseur de 1,2 μm environ), le réactif gazeux est mélangé à de l'hexane, à raison de 60 % en volume. Au bout d'un temps de 70 min (l'épaisseur du dépôt est alors de 3 μm), on arrête l'introduction du mélange gazeux.

Etude des propriétés de la couche mince obtenue :

Cette étude est effectuée comme décrit dans l'exemple 1.

a) Mesure de l'élasticité :

Résultat : 22 % de déformation résiduelle.

b) Mesure de la dureté :

Résultat : 2600 kg/$mm^2$

c) Mesure de l'adhérence :

Résultat : 550 kg/$cm^2$

d) Tenue en température :

Résultat : pas de dégradation évidente.

e) Analyse :

Par spectroscopie infra-rouge, on constate la présence de liaisons C-C ($sp^3$), C-C ($sp^2$), Si-C, Si-H et C-H. Par analyse aux rayons X, on détecte la présence d'argon libre sous forme interstitielle.

En spectroscopie de masse, on trouve une teneur en silicium de près de 40 % par rapport au poids total (Si + C).

## Revendications

1. Substrat solide revêtu sur au moins une partie de sa surface, d'une couche mince de carbone dur amorphe, caractérisé par le fait que ledit carbone dur amorphe est additionné de silicium et contient de l'argon.

2. Substrat selon la revendication 1, caractérisé par le fait que la teneur en silicium de la couche mince est sensiblement uniforme sur toute son épaisseur.

3. Substrat selon la revendication 1, caractérisé par le fait que la teneur en silicium décroît depuis les couches profondes vers les couches superficielles de la couche mince.

4. Composition selon l'une quelconque des revendications 1 et 3, caractérisée par le fait que ladite couche mince comprend des couches superficielles dont la teneur en silicium est nulle.

5. Substrat selon l'une quelconque des revendications précédentes, caractérisé par le fait que la proportion atomique
$$Si/(Si + C)$$
dans ladite couche mince, varie de 5 à 50 % et en particulier de 10 à 40 %.

6. Substrat selon l'une quelconque des revendications précédentes, caractérisé par le fait que ladite couche mince contient une proportion atomique de 0,1 à 10 % d'argon.

7. Substrat selon la revendication précédente, caractérisé par le fait que ladite couche mince contient de 0,1 à 5 % d'argon.

8. Substrat selon l'une quelconque des revendications précédentes, caractérisé par le fait ladite couche mince contient en outre au moins un agent dopant choisi parmi le bore, le phosphore, l'azote et le fluor.

9. Substrat selon la revendication 8, caractérisé par le fait que la teneur en agents dopants, dans ladite couche mince, est inférieure à la teneur en silicium, et est en particulier inférieure à 10 %.

10. Procédé de préparation d'un substrat tel que défini dans l'une quelconque des revendications précédentes, dans lequel on dépose, sur au moins une partie de la surface du substrat, par la méthode de dépôt chimique en phase gazeuse assisté par plasma, une couche mince de carbone amorphe additionné de silicium, au départ d'un réactif gazeux, caractérisé par le fait que l'on utilise comme réactif gazeux au moins un gaz contenant du silicium, éventuellement avec un hydrocarbure gazeux si le gaz contenant du silicium ne contient pas de carbone, et que ledit réactif gazeux contient de l'argon pendant au moins une partie de la durée de l'opération de dépôt de la couche mince.

**11.** Procédé selon la revendication 10, caractérisé par le fait que ledit gaz contenant du silicium est un organosilane.

**12.** Procédé selon la revendication 11, caractérisé par le fait que ledit réactif gazeux contient de 10 à 60 % d'argon en volume.

**13.** Procédé selon la revendication 11 ou 12, caractérisé par le fait que le réactif gazeux contient de l'argon pendant au moins 60 % de la durée de l'opération de dépôt de la couche mince.

**14.** Procédé selon la revendication précédente, caractérisé pan le fait que le réactif gazeux contient de l'argon pendant la totalité de ladite durée.

**15.** Procédé selon l'une quelconque des revendications 11 à 14, caractérisé par le fait que le réactif gazeux de départ contient en outre au moins un agent dopant choisi parmi l'azote et/ou un précurseur gazeux d'un agent dopant choisi parmi le bore, le phosphore et le fluor.

**16.** Procédé selon la revendication 15, caractérisé par le fait que ledit précurseur gazeux d'agent dopant est choisi parmi $N_2F_4$, $CF_2$, $SiF_4$, $PF_5$, $PH_3$ et $BF_3$.

**17.** Utilisation d'une couche mince telle que définie dans l'une quelconque des revendications 1 à 9, comme revêtement protecteur contre les agents chimiques, comme revêtement anti-usure, comme revêtement isolant électrique, comme revêtement décoratif ou comme revêtement conducteur de la chaleur.

Office européen des brevets

# RAPPORT DE RECHERCHE EUROPEENNE

Numero de la demande

EP 92 40 2029
Page 1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| X | EP-A-0 435 312 (KABUSHIKI KAISHA TOYOTA CHUO KENKYUSHO) | 1,2,10, 12-14,17 | C23C16/26<br>C23C16/30 |
| Y | * exemple 1 * | 3,8,11, 15,16 | |
| A | * page 3, ligne 37 - ligne 38 * | 4-7 | |
| | --- | | |
| Y | PATENT ABSTRACTS OF JAPAN<br>vol. 12, no. 444 (C-545)(3291) 22 Novembre 1988<br>& JP-A-63 166 970 ( SEIKO INSTR. AND ELECTRONICS LTD ) 11 Juillet 1988 | 3 | |
| A | * abrégé * | 4,5 | |
| | --- | | |
| A | PATENT ABSTRACTS OF JAPAN<br>vol. 12, no. 33 (C-472)(2880) 30 Janvier 1988<br>& JP-A-62 180 073 ( RICOH CO LTD ) 7 Août 1987<br>* abrégé * | 8,15 | |
| | --- | | |
| A | PATENT ABSTRACTS OF JAPAN<br>vol. 14, no. 342 (C-743)(4285) 24 Juillet 1990<br>& JP-A-21 25 877 ( SEMICONDUCTOR ENERGY LAB CO LTD ) 14 Mai 1990<br>* abrégé * | 5 | **DOMAINES TECHNIQUES RECHERCHES (Int. Cl.5 )**<br>C23C |
| | --- | | |
| Y | PATENT ABSTRACTS OF JAPAN<br>vol. 12, no. 438 (C-544)(3285) 17 Novembre 1988<br>& JP-A-63 162 871 ( NEC CORP ) 6 Juillet 1988 | 8,15,16 | |
| A | * abrégé * | 9 | |
| | --- | | |
| | -/-- | | |

Le présent rapport a été établi pour toutes les revendications

| Lieu de la recherche | Date d'achèvement de la recherche | Examinateur |
|---|---|---|
| LA HAYE | 26 OCTOBRE 1992 | EKHULT H.U. |

**CATEGORIE DES DOCUMENTS CITES**

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)

Office européen des brevets

# RAPPORT DE RECHERCHE EUROPEENNE

Numero de la demande

EP 92 40 2029
Page 2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | PATENT ABSTRACTS OF JAPAN<br>vol. 13, no. 111 (C-577)(3459) 16 Mars 1989<br>& JP-A-63 286 576 ( IDEMITSU PETROCHEM CO LTD ) 24 Novembre 1988 | 11 | |
| A | * abrégé *<br>--- | 4 | |
| A | EP-A-0 410 781 (NIPPON OIL CO. LTD)<br>* exemple 1 *<br>* colonne 4, ligne 30 - ligne 39 *<br>----- | 4 | |

DOMAINES TECHNIQUES RECHERCHES (Int. Cl.5)

Le présent rapport a été établi pour toutes les revendications

| Lieu de la recherche | Date d'achèvement de la recherche | Examinateur |
|---|---|---|
| LA HAYE | 26 OCTOBRE 1992 | EKHULT H.U. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)